# EUROPÄISCHE PATENTSCHRIFT

(11) **EP 2 044 817 B1**
(45) Veröffentlichungstag und Bekanntmachung des Hinweises auf die Patenterteilung: **11.06.2014**
(21) Anmeldenummer: 06762759.6
(22) Anmeldetag: 21.07.2006
(51) Int. Cl.: H05K 1/02, H05K 1/18

(54) **PLATINE MIT SCHWINGUNGSAUSLÖSENDEM ELEKTRONISCHEN BAUTEIL**
PRINTED CIRCUIT BOARD WITH VIBRATION-GENERATING ELECTRONIC COMPONENT
PLATINE AVEC COMPOSANT ÉLECTRONIQUE DÉCLENCHEUR DE VIBRATIONS

(43) Veröffentlichungstag der Anmeldung: 08.04.2009
(73) Patentinhaber: OSRAM GmbH, 80807 München (DE)
(72) Erfinder: SCHALLMOSER, Oskar, 85521 Ottobrunn (DE)
(86) Internationale Anmeldenummer: PCT/EP2006/007215
(87) Internationale Veröffentlichungsnummer: WO 2008/009308

(56) Entgegenhaltungen:
- EP-A- 0 654 959
- DE-A1- 2 838 288
- GB-A- 2 394 365

## Beschreibung

### Technisches Gebiet

Die Erfindung betrifft eine Platine, auf der zumindest zwei Leiterbahnen angeordnet sind, an denen ein elektronisches Bauteil angeschlossen ist, das im Betrieb Schwingungen auslöst.

### Stand der Technik

Eine Platine ist bekanntlich eine relativ dünne, flache Platte, die zumeist aus Kunststoff besteht. Die Leiterbahnen sind üblicherweise aus Kupfer hergestellt, wobei das Kupfer typischerweise elektrochemisch auf die Platine aufgebracht ist. Unter "Betrieb" des elektronischen Bauteils ist zu verstehen, dass das elektronische Bauteil stromdurchflossen ist bzw. dass zumindest eine Speisespannung anliegt.

Ein Beispiel für ein elektronisches Bauteil, das im Betrieb Schwingungen auslöst, ist ein Keramikkondensator. Da der Keramikkondensator auf der Platine montiert ist, bezeichnet man ihn auch als oberflächenmontierten Keramikkondensator (SMD-Keramikkondensator, surface mounted device). Keramikkondensatoren zeigen einen Piezoeffekt. Das Material zieht sich unter Spannung zusammen bzw. dehnt sich unter Spannung aus. In Abhängigkeit von der anliegenden Spannung kann eine Bewegung eingeleitet werden, insbesondere eine periodische, also oszillatorische Bewegung. Der oberflächenmontierte Keramikkondensator überträgt die Schwingungen auf die Platine, an der er befestigt ist. Auch wenn die Schwingung des Keramikkondensators unter dem Piezoeffekt nur eine sehr geringe Amplitude aufweist, kann es zu beträchtlichen Schwingungen in der Platine kommen, weil die wirkenden Kräfte sehr groß sind. Die schwingende Platine erzeugt Schall und damit unerwünschte wahrnehmbare Geräusche. Auch bei anderen elektronischen ren elektronischen Bauteilen können Schwingungen eingeleitet werden. Beispielsweise können elektrostatische und elektrodynamische Kräfte wirken. Ferrite zeigen die so genannte Magnetostriktion. Eine Ferrit-Magnetspule kann somit ebenfalls Schwingungen auslösen.

Es gibt im Stand der Technik mehrere Ansatzpunkte, wie eine Geräuschentwicklung nach außen hin verhindert werden kann. Ein erster Ansatzpunkt liegt in einer Verbesserung der Befestigung der schallemittierenden Bauteile an der Platine. Durch die Notwendigkeit der Bereitstellung elektrischer Kontakte können diese jedoch nicht immer wirksam abgekoppelt werden. Die Schallfrequenzen in den Steuersignalen, die den elektronischen Bauteilen zugeführt werden, können so gewählt werden, dass die mechanischen Schwingungen entsprechende Frequenzen zeigen, die nicht im hörbaren Bereich Schall erzeugen. Schließlich kann auch das Erzeugen von Schall zunächst in Kauf genommen werden und in einem Gehäuse, in dem die Platine untergebracht ist, dann eine Schalldämmungsmaßnahme erfolgen, beispielsweise durch Verwendung elastischer Vergussmassen, Dämm- oder Dämpfungsmatten.

In der Schrift GB 2394365 (Hansen) ist eine Platine mit einer Oszillatorschaltung offenbart, wobei die Oszillatorschaltung durch abgeknickt verlaufende Schlitze vom Rest der Platine inselförmig abgetrennt ist.

In der Schrift DE 28 38 288 (Tabuchi) ist ein scheibenförmiger piezoelektrischer Schwinger offenbart, der durch ringförmige Schlitze von einer Platine abgetrennt ist.

### Darstellung der Erfindung

Es ist Aufgabe der Erfindung, eine Platine der eingangs genannten Art derart weiter zu entwickeln, dass Schall wirksam unterdrückt wird.

Erfindungsgemäß wird in der Platine zumindest ein Schlitz bereitgestellt. Der Schlitz dient zum Verhindern einer Ausbreitung von durch das elektronische Bauteil ausgelösten Schwingungen über die Platine. Dies ist so zu verstehen, dass das elektrische Bauteil zunächst zwar in seinem unmittelbaren Einflussbereich Schwingungen auslösen kann, dass sich diese Schwingungen jedoch nur bis zu dem Schlitz hin an der Seite des Schlitzes, an der das elektronische Bauteil angeordnet ist, ausbreiten und nicht über den Schlitz hinaus, also auf der Seite des Schlitzes, an der das elektronische Bauteil nicht angeordnet ist. Da eine Platine üblicherweise eine flache Oberfläche aufweist, auf der die (Kupfer-)Leiterbahnen ausgebildet sind, bewirkt der Schlitz eine Unterbrechung in der flachen Oberfläche, so dass Oberflächenwellen und transversale Schwingungen der Platine über den Schlitz hinweg unterdrückt werden.

Bei einer bevorzugten Ausführungsform sind zwei Schlitze vorgesehen, und zwar an entgegengesetzten Seiten des elektronischen Bauteils. Die Schallausbreitung wird somit in zwei Richtungen unterbrochen. Selbstverständlich kann auch an einer dritten Seite des elektronischen Bauteils nochmals ein Schlitz vorgesehen sein. Die Schlitze können das elektronische Bauteil deswegen nicht vollständig umgeben, weil die Leiterbahnen an irgendeiner Stelle nach außen geführt werden müssen.

Bei einer bevorzugten Ausführungsform verläuft zumindest einer der Schlitze parallel zu einer Seitenwand des elektronischen Bauteils. Es sei ausdrücklich darauf hingewiesen, dass dieses Merkmal nicht bedingt, dass die Seitenwand des elektronischen Bauteils geradlinig ist. Ist die Seitenwand gekrümmt, so ist der Schlitz parallel dazu gekrümmt. Das Merkmal "parallel" beinhaltet lediglich, dass die jeweils kürzeste Verbindungslinie zwischen Seitenwand und Schlitz jeweils senkrecht auf den Tangenten an der Kontur der Seitenwand bzw. des Schlitzes steht. Die bevorzugte Ausführungsform, dass ein Schlitz parallel an der Seitenwand des elektronischen Bauteils verläuft, ist insbesondere dann besonders vorteilhaft, wenn das elektronische Bauteil im Bereich der Seitenwand, d. h. mit einem Ende, an den Leiterbahnen angeschlossen ist. Über den elektrischen Anschluss des elektronischen Bauteils an den Leiterbahnen, der mit einer mechanischen Verbindung einhergeht, erfolgt üblicherweise die mechanische Einkopplung der Schwingungen. Verläuft der Schlitz parallel zur Seitenwand des elektronischen Bauteils, so ist der Schlitz so angeordnet, dass jeweils ungefähr dieselbe Phase der Schwingung, die durch das elektronische Bauteil ausgelöst wird, zum Schlitz gelangt, und zwar über die gesamte Länge. Dadurch wird die Schwingung besonders effizient unterdrückt.

Ein Beispiel für die Form eines elektronischen Bauteils (z. B. eines typischen oberflächenmontierten Keramikkondensators) ist ein Bauteil mit einer rechteckigen Grundfläche, also mit zwei langen und zwei kurzen Seitenwänden. Der Schlitz kann parallel zur kurzen Seitenwand oder zur langen Seitenwand verlaufen (und ist dann naturgemäß geradlinig).

Bei einer bevorzugten Ausführungsform ist zumindest einer der Schlitze, der parallel zu einer Seitenwand des elektronischen Bauteils verläuft, länger als die Seitenwand. Der Schlitz ragt somit an zumindest einer Seite, bevorzugt an beiden Seiten, über die Breite der Seitenwand hinaus. Sinnvoll sind (bei einem Schlitz, der 50 µm bis 2 mm breit ist) Werte von bis zu 1 mm oder darüber hinaus bis zu 2 mm, um die der Schlitz länger als die Seitenwand ist.

Neben dem bereits erwähnten oberflächenmontierten Keramikkondensator kann das elektronische Bauteil eine (Ferrit-)Magnetspule sein. Die Erfindung findet Anwendung an sämtlichen elektronischen Bauteilen, die im Betrieb, also wenn sie stromdurchflossen sind oder wenn eine Spannung anliegt, Schwingungen auslösen und auf die Platine übertragen könnten.

### Kurze Beschreibung der Zeichnungen

Nachfolgend wird eine bevorzugte Ausführungsform der Erfindung unter Bezug auf die Zeichnung beschrieben, in der:
Fig. 1 eine Draufsicht auf eine Platine mit einem elektronischen Bauteil gemäß dem Stande der Technik veranschaulicht, und
Fig. 2 eine Draufsicht auf eine Platine mit einem elektronischen Bauteil gemäß einer Ausführungsform der Erfindung veranschaulicht.

### Bevorzugte Ausführung der Erfindung

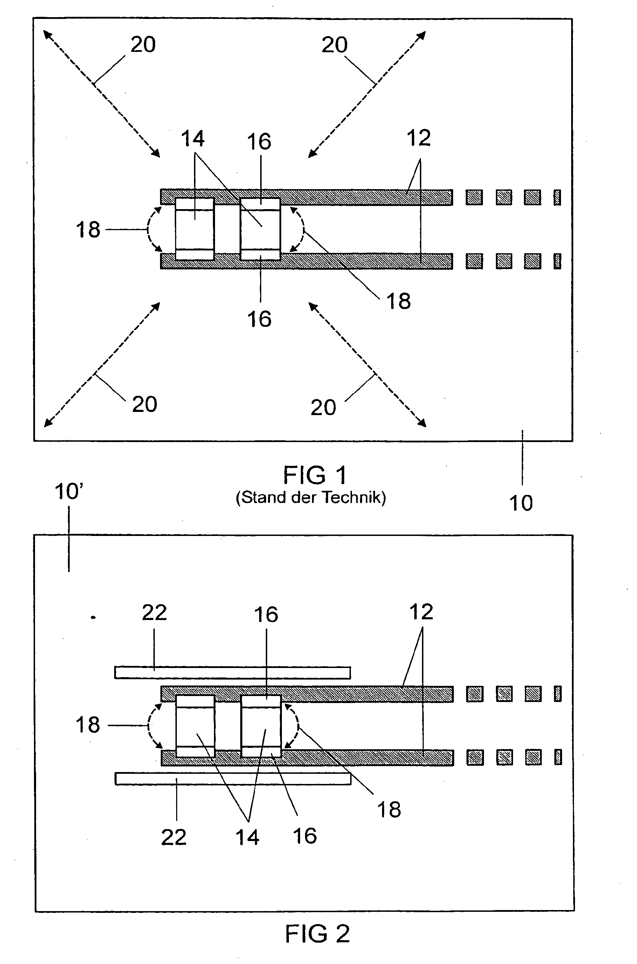

Fig. 1 zeigt eine Draufsicht auf eine Platine gemäß dem Stand der Technik. Eine Platine ist eine Kunststoffplatte, auf der elektrische Leiterbahnen aus Kupfer ausgebildet sind. Zur symbolischen Darstellung der Plattenform ist die Platine als Ganzes durch ein Rechteck gekennzeichnet und mit 10 bezeichnet. Dargestellt sind beispielhaft zwei Leiterbahnen 12, wobei deren Größe nicht maßstäblich im Verhältnis zur Platine 10 dargestellt ist. Durch die Punktierung am rechten Ende der Leiterbahnen 12 in der Darstellung gemäß Fig. 1 soll angedeutet sein, dass die Leiterbahnen auf beliebige Weise auf der Platine fortgesetzt sein können. Von Interesse ist der Kontaktbereich der Leiterbahn 12, an dem zwei Keramikkondensatoren 14 angeschlossen sind. Naturgemäß sind die Keramikkondensatoren 14 ebenfalls in der Draufsicht gezeigt. Sie haben einen rechteckigen Grundriss und sind mit Kontaktbereichen 16 jeweils an einer der Leiterbahnen 12 angeschlossen.

Im Betrieb der Keramikkondensatoren 14 wirkt der Piezoeffekt, d. h. die Keramikkondensatoren 14 verkürzen und verlängern sich, zum Beispiel periodisch. Die Bewegung ist durch die Pfeile 18 angedeutet, die deswegen gekrümmt sind, weil sich die Keramikkondensatoren 14 auch in Richtung senkrecht zur Papierebene der Fig. 1 ausdehnen. Über die Kontaktbereiche 16 übertragen die Keramikkondensatoren 14 diese Schwingungen auf die gesamte Platine 10, was durch die Pfeile 20 veranschaulicht ist. An keiner Stelle wird die Ausbreitung der Schwingungen, die durch die Pfeile 20 veranschaulicht sind, behindert. Die gesamte Platine 10 kommt ins Schwingen und strahlt Schall ab, und störende Geräusche sind die Folge.

Fig. 2 zeigt nun eine erfindungsgemäße Platine 10' in der Draufsicht in einer zur Fig. 1 analogen Darstellung. Erfindungsgemäß sind zwei Schlitze 22 in der Platine 10' vorgesehen, z. B. eingefräst. Jeder Schlitz 22 verläuft parallel zur kurzen Seitenwand der Keramikkondensatoren 14, welche ja eine rechteckige Grundfläche aufweisen. Die Schlitze 22 laufen insbesondere parallel zu den Kontaktbereichen 16. Die Schlitze sind an beiden Seiten der Kondensatoren etwas verlängert. Die Schlitze 22 enden nicht in der Verlängerung der in Fig. 2 linken langen Seitenwand des links gezeigten Keramikkondensators 14, sondern erstrecken sich noch etwas weiter, den übrigen Verlauf verlängert nach links in die Platine 10' hinein. Die Schlitze enden auch nicht in der Verlängerung der in der Fig. 2 rechten langen Seitenwand des rechts dargestellten Keramikkondensators 14, sondern ragen nach rechts in Verlängerung ihrer übrigen Erstreckung darüber hinaus. Die Schlitze 22 unterbinden eine Ausbreitung von Schwingungen. Auch hier schwingen die Keramikkondensatoren 14, so wie es durch die Pfeile 18 angedeutet ist. Die Schwingungen können sich jedoch allenfalls im Bereich zwischen den Schlitzen 22 auf die Platine übertragen. Sie können sich jedoch nicht über die Schlitze 22 hinweg in den Bereich jenseits der Schlitze 22 (Keramikkondensatoren sind "diesseits") ausbreiten. Eine großflächige Ausbreitung des Schalls wie im Stand der Technik (vergleiche Pfeile 20 in Fig. 1) ist durch die Schlitze 22 unterbunden. Dadurch wird wirksam eine Schallabstrahlung verhindert.

In der dargestellten Form sind die Schlitze 22 auch parallel zu den Leiterbahnen 12. Es wäre zur weiteren Unterdrückung von Schallabstrahlung auch möglich, einen zusätzlichen Schlitz parallel zur in Fig. 2 linken langen Seitenwand des links gezeigten Keramikkondensators 14 auszubilden. Einschränkungen ergeben sich allenfalls aus einer möglichen Instabilität der Platine.

Die Form der Schlitze kann nicht in jedem Fall so ideal ausgebildet sein wie bei den dargestellten Schlitzen 22. Insbesondere die Form und der Verlauf von Leiterbahnen kann die Form der Schlitze bestimmen. So ist es nicht immer möglich, dass ein streifenförmiger Kontaktbereich 16 ausgebildet ist, der seinerseits parallel zum Verlauf der Leiterbahn ist und zu dem parallel ein Schlitz 22 ausgebildet sein kann. Es ist vielmehr möglich, dass Kontaktbereiche der Keramikkondensatoren mit den Leiterbahnen nicht-rechteckig sind, zum Beispiel wenn die Leiterbahnen ihrerseits nicht streifenförmig sind. Idealerweise orientiert sich die Platzierung eines Schlitzes daran, wie in der Platine ohne das Vorhandensein des Schlitzes eine Schallausbreitung erfolgen würde, denn die Schlitze sollen ja eine Ausbreitung von durch den Keramikkondensator ausgelösten Schwingungen über die Platine gerade verhindern.

Eine erfindungsgemäße Platine kann eine Vielzahl von Keramikkondensatoren aufweisen. Nicht immer kann für zwei Keramikkondensatoren gleichzeitig ein Schlitz ausgebildet werden. Vielmehr ist es möglich, dass zu jedem Keramikkondensator einzeln in der Platine im Nahbereich des Keramikkondensators Schlitze ausgebildet werden. Naturgemäß können gegebenenfalls mehrere Keramikkondensatoren, wie in Fig. 2 dargestellt, zusammen von Schlitzen umgeben werden.

## Patentansprüche

1. Platine (10'), auf der zumindest zwei Leiterbahnen (12) angeordnet sind, an denen ein elektronisches Bauteil (14) angeschlossen ist, das im Betrieb Schwingungen (18) auslöst,
und mit
zumindest einem in der Platine (10') ausgebildeten Schlitz (22) zum Verhindern einer Ausbreitung von durch das elektronische Bauteil ausgelösten Schwingungen (20) über die Platine,
wobei die Platine (10'),
**gekennzeichnet ist durch**
zwei an entgegengesetzten Seiten des elektronischen Bauteils (14) angeordnete Schlitze (22),
wobei
zumindest einer der Schlitze (22) parallel zu einer Seitenwand des elektronischen Bauteils (14) verläuft.
und wobei
das elektronische Bauteil eine rechteckige Grundfläche mit zwei langen und zwei kurzen Seitenwänden hat und der zumindest eine Schlitz (22) geradlinig parallel zu den kurzen Seitenwänden verläuft.

2. Platine nach Anspruch 1,
**dadurch gekennzeichnet, dass**
das elektronische Bauteil eine rechteckige Grundfläche mit zwei langen und zwei kurzen Seitenwänden hat und der zumindest eine Schlitz geradlinig parallel zu den langen Seitenwänden verläuft.

3. Platine (10') nach einem der Ansprüche 1 bis 2,
**dadurch gekennzeichnet, dass**
zumindest eine der Schlitze (22), der parallel zu einer Seitenwand des elektronischen Bauteils (14) verläuft, länger als die Seitenwand ist.

4. Platine (10') nach einem der vorhergehenden Ansprüche,
**dadurch gekennzeichnet, dass**
das elektronische Bauteil ein oberflächenmontierter Keramikkondensator (14) ist.

5. Platine nach einem der Ansprüche 1 bis 3,
**dadurch gekennzeichnet, dass**
das elektronische Bauteil eine Magnetspule ist.

## Claims

1. Printed circuit board (10'), on which at least two conductor tracks (12) are arranged, to which an electronic component (14) is connected which triggers oscillations (18) during operation, and having at least one slot (22) formed in the printed circuit board (10') for preventing the propagation of oscillations (20) triggered by the electronic component over the printed circuit board, wherein the printed circuit board (10') is **characterized by** two slots (22) arranged on opposite sides of the electronic component (14), wherein at least one of the slots (22) runs parallel to a side wall of the electronic component (14), and wherein the electronic component has a rectangular base area with two long and two short side walls, and the at least one slot (22) runs in a straight line parallel to the short side walls.

2. Printed circuit board according to Claim 1, **characterized in that** the electronic component has a rectangular base area with two long and two short side walls, and the at least one slot runs in a straight line parallel to the long side walls.

3. Printed circuit board (10') according to either of Claims 1 and 2, **characterized in that** at least one of the slots (22), which runs parallel to a side wall of the electronic component (14), is longer than the side wall.

4. Printed circuit board (10') according to one of the preceding claims, **characterized in that** the electronic component is a surface-mounted ceramic capacitor (14).

5. Printed circuit board according to one of Claims 1 to 3, **characterized in that** the electronic component is a magnet coil.

## Revendications

1. Platine (10'), sur laquelle sont disposées au moins deux pistes conductrices (12), auxquelles est raccordé un composant électronique (14) qui déclenche des vibrations (18) en fonctionnement,
et comprenant
au moins une fente (22) réalisée dans la platine (10') pour empêcher une propagation à la platine des vibrations (20) déclenchées par le biais du composant électronique, dans lequel la platine (10')
est **caractérisée par**
deux fentes (22) disposées sur des côtés opposés du composant électronique (14),
dans laquelle
au moins une des fentes (22) est parallèle à une paroi latérale du composant électronique (14),
et dans laquelle
le composant électronique a une surface de base rectangulaire avec deux parois latérales longues et deux parois latérales courtes et l'au moins une fente (22) est parallèle et rectiligne par rapport aux parois latérales courtes.

2. Platine selon la revendication 1,
**caractérisée en ce que**
le composant électronique a une surface de base rectangulaire avec deux parois latérales longues et deux parois latérales courtes et l'au moins une fente est parallèle et rectiligne par rapport aux parois latérales longues.

3. Platine (10') selon l'une des revendications 1 à 2,
**caractérisée en ce qu'**
au moins une des fentes (22), qui est parallèle à une paroi latérale du composant électronique (14), est plus longue que la paroi latérale.

4. Platine (10') selon l'une des revendications précédentes,
**caractérisée en ce que**
le composant électronique est un condensateur céramique (14) monté en surface.

5. Platine selon l'une des revendications 1 à 3,
**caractérisée en ce que**
le composant électronique est une bobine magnétique.
